# EUROPEAN PATENT APPLICATION

(11) **EP 2 988 337 A1**
(43) Date of publication of application: **24.02.2016**
(21) Application number: 14784884.0
(22) Date of filing: 15.04.2014
(51) Int. Cl.: H01L 31/0749

(54) **SOLAR CELL AND METHOD FOR MANUFACTURING SOLAR CELL**

(30) Priority: 16.04.2013 JP 2013085922
(71) Applicant: Solar Frontier K.K., Minato-ku Tokyo 135-8074 (JP)
(72) Inventor: HIROI, Homare, Tokyo 135-8074 (JP); SUGIMOTO, Hiroki, Tokyo 135-8074 (JP); KATOU, Takuya, Tokyo 135-8074 (JP); SAKAI, Noriyuki, Tokyo 135-8074 (JP)
(74) Representative: Hoffmann Eitle
(86) International application number: PCT/JP2014/060732
(87) International publication number: WO 2014/171458

(57) **Abstract**

A method for manufacturing a solar cell includes the following steps: a step in which a first electrode layer (12) is formed on top of a substrate (11); a step in which a selenium-containing p-type CZTS light-absorbing layer (13) is formed on top of the first electrode layer (12); a step in which the surface of the CZTS light-absorbing layer (13) is brought into contact with an aqueous solution containing an organic sulfur compound, increasing the concentration of sulfur on the surface of the CZTS light-absorbing layer (13), and an n-type buffer layer (14) is formed on top of CZTS light-absorbing layer (13); and a step in which a second electrode layer (15) is formed on top of said buffer layer (14).

## Description

### Field of the Invention

The present invention relates to a solar cell and a method of manufacturing the same.

### Description of the Related Art

In recent years, thin-film solar cells containing a Group I₂-(II-IV)-VI₄ compound semiconductor as a p-type light-absorbing layer have been drawing attention. Thin-film solar cells in which a chalcogenide-based Group I₂-(II-IV)-VI₄ compound semiconductor containing Cu, Zn, Sn, S or Se is used as a p-type light-absorbing layer are referred to as "CZTS-based thin-film solar cells", and representative examples thereof include Cu₂ZnSnSe₄ and Cu₂ZnSn(S,Se)₄ solar cells.

CZTS-based thin-film solar cells not only use materials that are relatively inexpensive and readily available and can be produced by a relatively easy method, but also have high absorption coefficient in the wavelength range of visible light to near-infrared radiation and is thus expected to exhibit high photoelectric conversion efficiency; therefore, such CZTS-based thin-film solar cells are considered as promising candidates for next-generation solar cell.

A CZTS-based thin-film solar cell is produced by forming a backside metal electrode layer on a substrate, forming a p-type CZTS light-absorbing layer thereon and further sequentially laminating an n-type high-resistance buffer layer and an n-type transparent conductive film. As the material of the backside metal electrode layer, a high-corrosion-resistance and high-melting-point material such as molybdenum (Mo), titanium (Ti) or chrome (Cr) is used. The p-type CZTS light-absorbing layer is prepared by, for example, forming a Cu-Zn-Sn or Cu-Zn-Sn-Se-S precursor film by a sputtering method or the like on a substrate on which a molybdenum (Mo) backside metal electrode layer has been formed and then subjecting the precursor film to sulfurization in a hydrogen sulfide atmosphere or selenization in a hydrogen selenide atmosphere.

### Prior Art References

### Patent Documents

[Patent Document 1] Japanese Laid-open Patent Publication No. 2012-160556
[Patent Document 2] Japanese Laid-open Patent Publication No. 2012-253239

### Summary of the Invention

### Problems to be Solved by the Invention

The underlying potential of CZTS-based thin-film solar cells is high; however, their photoelectric conversion efficiencies that have been realized until now are lower than the theoretical value and, therefore, further improvement in the production technique is necessary.

The present invention was made relating to this point, and an object of the present invention is to propose a solar cell including a CZTS light-absorbing layer having improved photoelectric conversion efficiency.

Another object of the present invention is to propose a method of manufacturing a solar cell including a CZTS light-absorbing layer having improved photoelectric conversion efficiency.

### Means for Solving the Problems

The solar cell according to the present invention includes: a substrate; a first electrode layer arranged on the substrate; a p-type CZTS light-absorbing layer that is arranged on the first electrode layer and contains selenium and sulfur; an n-type buffer layer arranged on the CZTS light-absorbing layer; and a second electrode layer arranged on the buffer layer, wherein, in the depth direction of the CZTS light-absorbing layer, the sulfur concentration increases toward an interface on the buffer layer side.

Further, the method of manufacturing a solar cell according to the present invention includes the steps of: forming a first electrode layer on a substrate; forming a selenium-containing p-type CZTS light-absorbing layer on the first electrode layer; bringing a surface of the CZTS light-absorbing layer into contact with an aqueous solution containing an organic sulfur compound so as to increase the sulfur concentration on the surface of the CZTS light-absorbing layer; forming an n-type buffer layer on the CZTS light-absorbing layer; and forming a second electrode layer on the buffer layer.

### Effects of the Invention

According to the solar cell of the present invention, improved photoelectric conversion efficiency can be attained.

Further, by the method of manufacturing a solar cell according to the present invention, a solar cell having improved photoelectric conversion efficiency can be obtained.

### Brief Description of the Drawings

[FIG. 1] FIG. 1 is a drawing that illustrates the cross-sectional structure of a solar cell disclosed in the present specification.
[FIG. 2] FIG. 2 is a drawing that illustrates the band structures of the CZTS light-absorbing layer and buffer layer of the solar cell depicted in FIG. 1.
[FIG. 3A] FIG. 3A is a drawing that illustrates one embodiment of the method of manufacturing a solar cell according to the present invention.
[FIG. 3B] FIG. 3B is a drawing that illustrates one embodiment of the method of manufacturing a solar cell according to the present invention.
[FIG. 3C] FIG. 3C is a drawing that illustrates one embodiment of the method of manufacturing a solar cell according to the present invention.
[FIG. 3D] FIG. 3D is a drawing that illustrates one embodiment of the method of manufacturing a solar cell according to the present invention.
[FIG. 4] FIG. 4 illustrates the production conditions of Experimental Examples 1 and 2 and Comparative Experimental Example that are disclosed in the present specification.
[FIG. 5] FIG. 5 illustrates the production conditions and evaluation results of Experimental Examples 1 and 2 and Comparative Experimental Example that are disclosed in the present specification.
[FIG. 6] FIG. 6 is a graph illustrating the current density-voltage characteristics of Experimental Examples 1 and 2 and Comparative Experimental Example that are disclosed in the present specification.
[FIG. 7] FIG. 7 is a graph illustrating the sulfur distribution in the depth direction of Experimental Example 1 and Comparative Experimental Example that are disclosed in the present specification.
[FIG. 8] FIG. 8 is a drawing that illustrates the band structures of the CZTS light-absorbing layer and buffer layer of a solar cell of one embodiment according to the present invention.

### Mode for Carrying Out the Invention

Preferred embodiments of the solar cell and the method of manufacturing a solar cell that are disclosed in the present specification will now be described referring to the figures. However, it should be note that the technical scope of the present invention is not restricted to these embodiments and extends to the inventions described in claims as well as equivalents thereof.

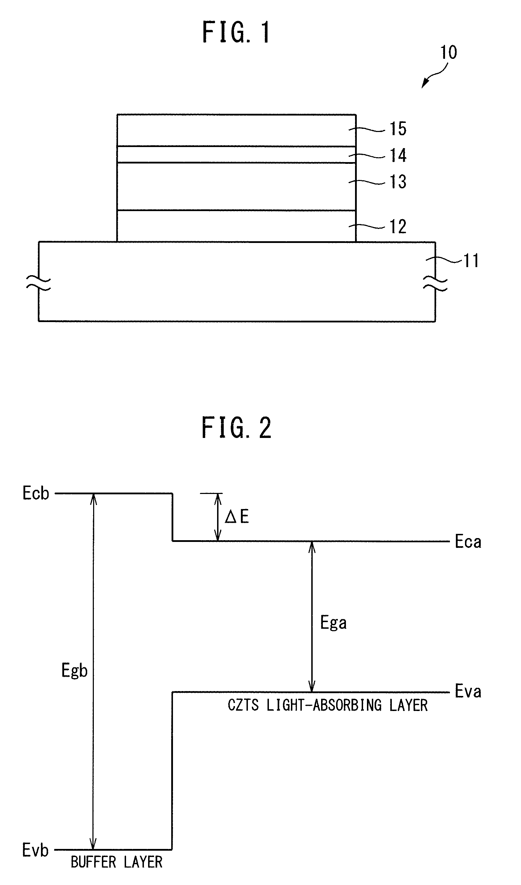

FIG. 1 is a drawing that illustrates the cross-sectional structure of a solar cell disclosed in the present specification.

A solar cell 10 includes: a substrate 11; a first electrode layer 12 arranged on the substrate 11; a p-type CZTS light-absorbing layer 13 arranged on the first electrode layer 12; an n-type buffer layer 14 arranged on the CZTS light-absorbing layer 13; and a second electrode layer 15 arranged on the buffer layer 14.

As the substrate 11, for example, a glass substrate such as a soda lime glass or a low-alkali glass, a metal substrate such as a stainless steel sheet, or a polyimide resin substrate can be used. As the first electrode layer 12, for example, a metal conductive layer made of a metal such as Mo, Cr or Ti can be used.

The CZTS light-absorbing layer 13 is prepared by forming a metal precursor film containing Cu, Zn and Sn on the first electrode layer 12 and then subjecting the thus formed metal precursor film to sulfurization and selenization in a hydrogen sulfide atmosphere and a hydrogen selenide atmosphere, respectively, at 500°C to 650°C. In this manner, the p-type CZTS light-absorbing layer 13 including Cu₂ZnSn(S,Se)₄ is formed.

The n-type high-resistance buffer layer 14 is formed on the CZTS light-absorbing layer 13. The buffer layer 14 is, for example, a thin film of a compound containing Cd and Zn (film thickness: 3 nm to 50 nm or so) and typically formed using CdS, ZnO, ZnS, Zn(OH)₂, or a mixed crystal thereof which is Zn(O,S,OH). This layer is generally formed by chemical bath deposition (CBD method); however, as a dry process, metal organic chemical vapor deposition (MOCVD method) or atomic layer deposition (ALD method) can also be employed. The "CBD method" is a method in which a base material is immersed in a solution that contains a chemical species forming a precursor and heterogeneous reaction is allowed to proceed between the solution and the surface of the base material, thereby causing a thin film to precipitate on the base material.

The n-type transparent second electrode layer 15 is then formed on the buffer layer 14 to obtain the solar cell 10. The second electrode layer 15 is formed at a film thickness of 0.05 to 2.5 µm or so using a low-resistance material that has n-type conductivity and a wide band-gap and is transparent. Representative examples of the second electrode layer 15 include a zinc oxide-based thin film (ZnO) and an ITO thin film. In the case of a ZnO film, a low-resistance film can be obtained by adding thereto a Group III element (for example, Al, Ga or B) as a dopant. In addition to an MOCVD method, the second electrode layer 15 can also be formed by a sputtering method (DC or RF) or the like.

The present inventors investigated to further improve the photoelectric conversion efficiency of a solar cell that is obtained by the above-described steps and equipped with a CZTS light-absorbing layer. Specifically, a means for improving the fill factor to attain superior photoelectric conversion efficiency was investigated. In this process, the present inventors focused their attention on the energy difference ΔE between the energy level Eca at the lower end of the conduction band of the CZTS light-absorbing layer 13 and the energy level Ecb at the lower end of the conduction band of the buffer layer 14.

FIG. 2 is a drawing that illustrates the band structures of the CZTS light-absorbing layer and buffer layer of the solar cell depicted in FIG. 1.

The energy level Ecb at the lower end of the conduction band of the buffer layer 14 is higher than the energy level Eca at the lower end of the conduction band of the CZTS light-absorbing layer 13.

A large energy difference ΔE works as a barrier for the movement of excited electrons in the conduction band of the CZTS light-absorbing layer 13 to the buffer layer 14 and the series resistance is consequently increased; therefore, a large energy difference ΔE is believed to cause a reduction in the fill factor.

In FIG. 2, Ega represents a band-gap energy that is the difference between the energy level Eca at the lower end of the conduction band and the energy level Eva at the upper end of the valence band in the CZTS light-absorbing layer 13. Further, Egb represents a band-gap energy that is the difference between the energy level Ecb at the lower end of the conduction band and the energy level Evb at the upper end of the valence band in the buffer layer 14.

For a reduction of the energy difference ΔE, it was investigated to increase the band-gap energy Ega of the CZTS light-absorbing layer 13.

The band-gap energy of Cu₂ZnSnSe₄ forming the CZTS light-absorbing layer 13 is about 1.0 eV. Meanwhile, the band-gap energy of Cu₂ZnSnS₄, which is another CZTS-based compound, is greater than that of Cu₂ZnSnSe₄ at about 1.5 eV.

Thus, it was investigated to increase the band-gap energy Ega of the CZTS light-absorbing layer 13 by subjecting the Se atom-containing CZTS light-absorbing layer 13 to an increase in the S atoms contained therein or substitution of the Se atoms with S atoms.

However, crystals of Cu₂ZnSn(Se,S)₄ in which the S atom content is increased or the Se atoms are substituted with S atoms may cause a reduction in the open-circuit voltage due to crystal defects. Therefore, an increase in the S atoms or substitution of the Se atoms with S atoms throughout a Cu₂ZnSn(Se,S)₄ layer may cause crystal defects throughout the Cu₂ZnSn(Se,S)₄ layer, leading to a reduction in the photoelectric conversion efficiency.

In view of this, it was decided to increase the band-gap energy Ega in the vicinity of the surface of the CZTS light-absorbing layer 13 by subjecting the Se atom-containing CZTS light-absorbing layer 13 to an increase in the S atoms contained in the vicinity of its surface or substitution of the Se atoms with S atoms. Specific examples of the Se atom-containing CZTS light-absorbing layer 13 include Cu₂ZnSnSe₄ and Cu₂ZnSn(Se,S)₄.

The present inventors propose a method of manufacturing a solar cell, in which the effect of an increase in the S atom concentration on the photoelectric conversion efficiency is suppressed and the photoelectric conversion efficiency is improved by a reduction in the energy difference ΔE, as follows.

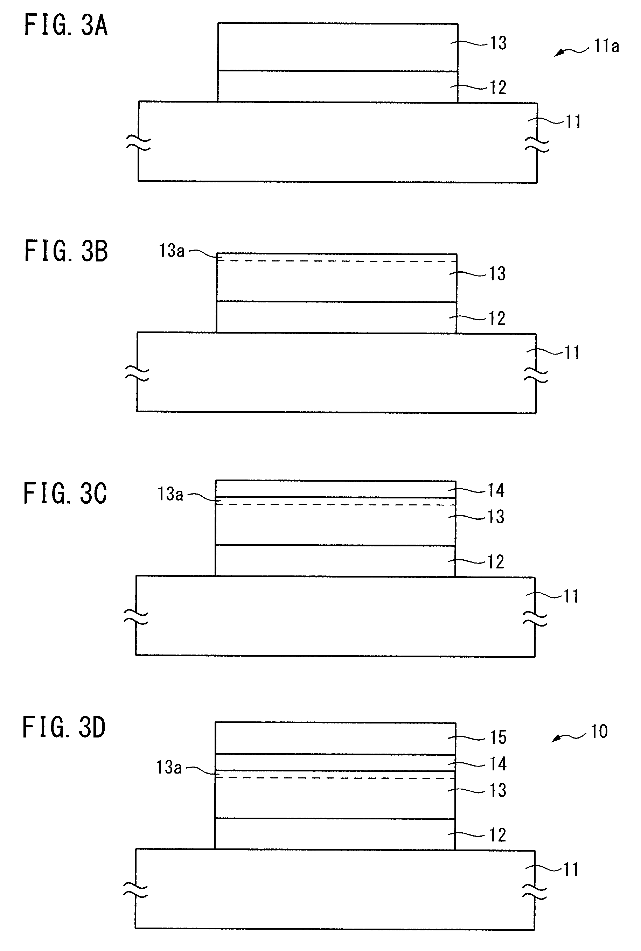

An embodiment of the method of manufacturing a solar cell according to the present invention will now be described referring to FIGs. 3 to 5.

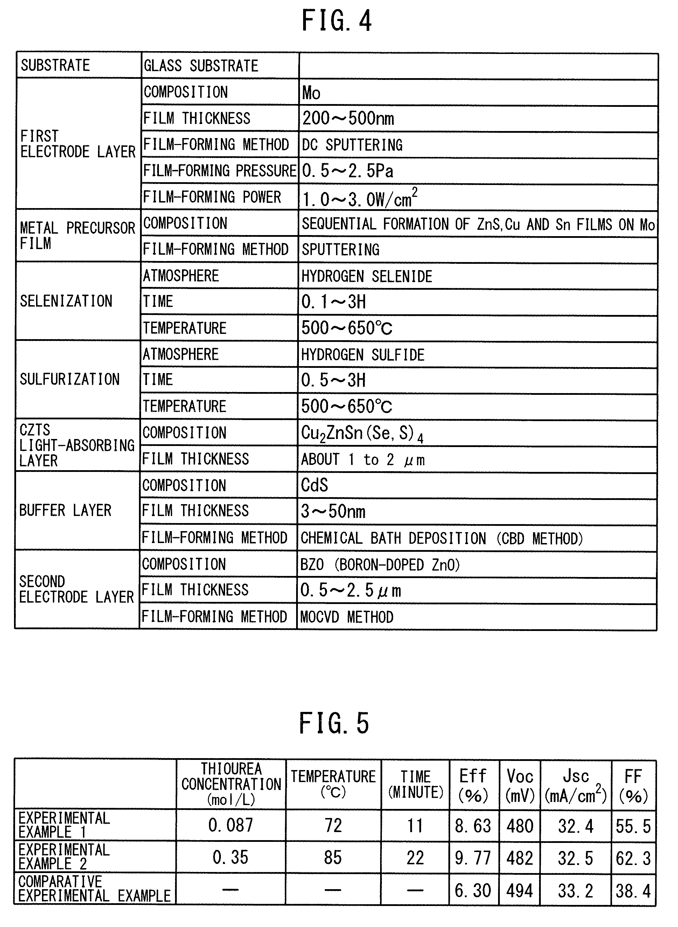

First, as illustrated in FIG. 3A, a substrate complex 11a, in which a first electrode layer 12 is formed on a substrate 11 and a selenium-containing p-type CZTS light-absorbing layer 13 is formed on the first electrode layer 12, is produced. The concrete production conditions used in the step of FIG. 3A of this embodiment are summarized in FIG. 4.

In this embodiment, the CZTS light-absorbing layer 13 is subjected to not only selenization but also sulfurization. This is because the photoelectric conversion efficiency is improved by performing both selenization and sulfurization. The present inventors had confirmed that an improved photoelectric conversion efficiency is attained when some of the Se atoms, which are VI Group elements, of Cu₂ZnSnSe₄ are substituted with S atoms. The degree of sulfurization can be determined based on the balance between the photoelectric conversion efficiency resulting from the defects attributed to an increase in S atoms and the effect of improving the photoelectric conversion efficiency.

The reason why the photoelectric conversion efficiency is improved by substitution of some of the Se atoms with S atoms is because the energy band gap of the crystal is thereby approximated to an optimum band gap conforming to the solar spectrum. However, it has been empirically proven that the defects causing a reduction in the open-circuit voltage increase as the S atom content increases and therefore, the conversion efficiency is maximized when the ratio of the sulfur concentration with respect to a sum of the sulfur concentration and the selenium concentration (chalcogen ratio: S/(S + Se)) is about 20%.

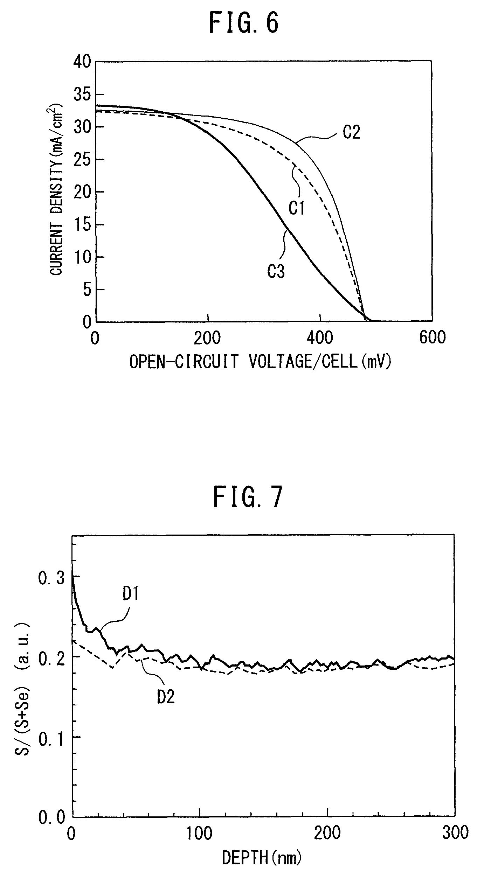

The degree of selenization and that of sulfurization in this embodiment will be described later referring to FIG. 7. It is noted here that the CZTS light-absorbing layer 13 may be subjected only to selenization and sulfurization does not have to be performed.

Next, as illustrated in FIG. 3B, the surface of the CZTS light-absorbing layer 13 is brought into contact with an aqueous solution containing an organic sulfur compound to form a region 13a where the sulfur concentration is increased in the surface of the CZTS light-absorbing layer 13. In the present specification, an increase in the sulfur concentration in the surface of the CZTS light-absorbing layer 13 includes: when the CZTS light-absorbing layer 13 contains sulfur, an increase in the sulfur concentration; and, when the CZTS light-absorbing layer 13 does not contain any sulfur, an increase in the sulfur concentration by an addition of sulfur.

As the organic sulfur compound, it is preferred to use thiourea, thioacetamide or a mixture thereof. Alternatively, as the organic sulfur compound, thioacetamide, thiosemicarbazide, thiourethane or the like may also be used.

In this embodiment, the substrate complex 11a was immersed in an aqueous solution prepared by dissolving an organic sulfur compound in pure water. As the organic sulfur compound, thiourea was used. It is preferred that the aqueous solution contain no metal salt of Cd, Zn or the like.

In this embodiment, solar cells of Experimental Examples 1 and 2 were produced under different production conditions of the step of FIG. 3B. The concrete production conditions used in the step of FIG. 3B of this embodiment are summarized in FIG. 5. In Experimental Example 1, the substrate complex 11a was immersed for 11 minutes in an aqueous solution having a thiourea concentration of 0.087 mol/L and a temperature of 72°C. In Experimental Example 2, the substrate complex 11a was immersed for 22 minutes in an aqueous solution having a thiourea concentration of 0.35 mol/L and a temperature of 85°C.

Next, as illustrated in FIG. 3C, an n-type buffer layer 14 is formed on the CZTS light-absorbing layer 13. The n-type buffer layer 14 forms a p-n junction with the interface of the p-type CZTS light-absorbing layer 13 having the region 13a. The concrete production conditions used in the step of FIG. 3C of this embodiment are summarized in FIG. 4.

Then, as illustrated in FIG. 3D, by forming a second electrode layer 15 on the buffer layer 14, a solar cell 10 of this embodiment is obtained. The concrete production conditions used in the step of FIG. 3D of this embodiment are summarized in FIG. 4.

Further, for comparison with Experimental Examples 1 and 2, a solar cell of Comparative Experimental Example was produced. In this Comparative Experimental Example, the step of FIG. 3B was not performed.

The photoelectric conversion efficiency and the current density-voltage characteristics were evaluated for the above-described Experimental Examples 1 and 2 and Comparative Experimental Example. The evaluation results are shown in FIGs. 5 and 6.

In FIG. 6, curves C1, C2 and C3 represent the properties of Experimental Example 1, Experimental Example 2 and Comparative Experimental Example, respectively.

In Experimental Examples 1 and 2, as compared to Comparative Experimental Example, the fill factor FF and the photoelectric conversion efficiency Eff were largely improved.

Further, Experimental Example 2 exhibited a higher fill factor FF and a higher photoelectric conversion efficiency Eff as compared to those of Experimental Example 1. It is believed that the sulfur concentration of the region 13a in the CZTS light-absorbing layer 13 of Experimental Example 2 is higher than that of Experimental Example 1 due to the differences in the production conditions used in the step of FIG. 3B.

With regard to the open-circuit voltage Voc and the short-circuit current density Jsc, Experimental Examples 1 and 2 exhibited substantially the same values as those of Comparative Experimental Example.

Next, the results of measuring the sulfur concentration in the depth direction of the CZTS light-absorbing layer 13 for Experimental Example 2 and Comparative Experimental Example will be described referring to FIG. 7.

FIG. 7 represents the results of measuring the sulfur concentration (atomic concentration) by a glow discharge method while grinding the sample surface by a sputtering method. In FIG. 7, the abscissa represents the depth from the interface on the buffer layer 14 side of the CZTS light-absorbing layer 13, and the ordinate represents the ratio between the sulfur concentration and a sum of the sulfur concentration and the selenium concentration (chalcogen ratio: S/(S + Se)). In FIG. 7, curves D1 and D2 represent the chalcogen ratio distribution of Experimental Example 2 and that of Comparative Experimental Example, respectively.

The chalcogen ratio in the CZTS light-absorbing layer 13 of Experimental Example 2 increases from the part at a depth of about 50 nm from the interface on the side of the buffer layer 14 toward the interface on the side of the buffer layer 14. Specifically, the chalcogen ratio of the part at a depth of about 20 nm from the interface on the side of the buffer layer 14 is increased to about 1.2 times as that of the part at a depth of about 50 nm. Further, the chalcogen ratio at the interface on the side of the buffer layer 14 is increased to about 1.5 times as that of the part at a depth of about 50 nm.

On the other hand, the chalcogen ratio in the CZTS light-absorbing layer 13 of Comparative Experimental Example is distributed at about 0.2 throughout the depth direction from the interface on the buffer layer 14 side of the CZTS light-absorbing layer 13.

In those parts at a depth of greater than about 50 nm from the interface on the buffer layer 14 side, the chalcogen ratio in the CZTS light-absorbing layer 13 of Experimental Example 2 is comparable to that of Comparative Experimental Example. Therefore, it is seen that the effect of the treatment by the step of FIG. 3B was limited to the vicinity of the surface of the CZTS light-absorbing layer 13.

The present inventors believe with regard to the reason why the solar cells of Experimental Examples 1 and 2 exhibited superior fill factor FF and photoelectric conversion efficiency Eff than those of Comparative Experimental Example as follows.

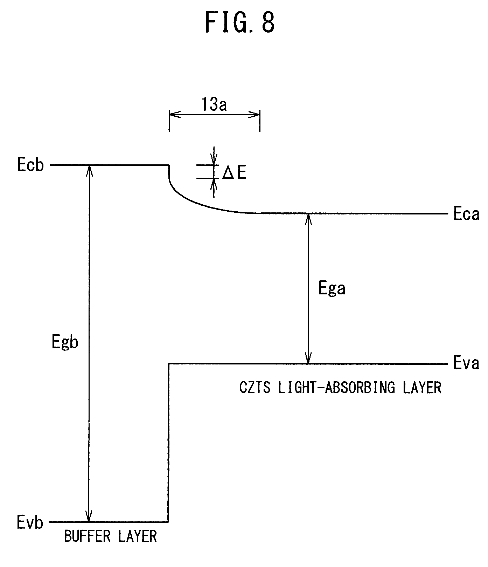

FIG. 8 is a drawing that illustrates the band structures of the CZTS light-absorbing layer and buffer layer of a solar cell according to one embodiment of the present invention that encompasses the solar cells of Experimental Examples 1 and 2.

As illustrated in FIG. 7, in the region 13a, the chalcogen ratio in the depth direction of the CZTS light-absorbing layer 13 increases toward the interface on the buffer layer 14 side. It is thus believed that, in the region 13a, the energy level Eca at the lower end of the conduction band increases along with the increase in the chalcogen ratio.

Accordingly, in the band structure of the CZTS light-absorbing layer 13 illustrated in FIG. 8, the energy level Eca at the lower end of the conduction band increases toward the interface with the buffer layer 14 and the energy difference ΔE at the junction between the CZTS light-absorbing layer 13 and the buffer layer 14 is reduced.

In those parts of the CZTS light-absorbing layer 13 other than the region 13a, neither an increase in S atoms nor substitution of Se atoms with S atoms by the step of FIG. 3B was substantially performed; therefore, it is believed that no defect attributed to an increase in S atoms occurred.

Generally speaking, for improvement of the series resistance, it is desired that the energy difference ΔE be 0.4 eV or less; however, for inhibition of leak current, it is desired that the energy difference ΔE be 0.0 eV or greater. Therefore, it is believed that a conversion efficiency-improving effect by an improvement of the series resistance can be obtained by increasing the chalcogen ratio of the junction surface to an upper limit of about 0.5 eV for a CdS-based buffer layer or an upper limit of about 1.0 eV for a ZnS-based buffer layer.

The results of the chalcogen ratio distributions illustrated in FIG. 7 correspond to the presence of the band structures illustrated in FIG. 8. Accordingly, in the CZTS light-absorbing layer 13 of Experimental Example 2, it is speculated that the energy level Eca at the lower end of the conduction band increased toward the interface with the buffer layer 14 and that the energy difference ΔE at the junction between the CZTS light-absorbing layer 13 and the buffer layer 14 was thereby reduced as compared to Comparative Experimental Example. Further, it is speculated that, in the CZTS light-absorbing layer 13 of Experimental Example 1 as well, the energy difference ΔE was reduced in the same manner as compared to Comparative Experimental Example.

Therefore, why there is a large improvement in the fill factor FF and the photoelectric conversion efficiency Eff of Experimental Examples 1 and 2 as compared to those of Comparative Experimental Example, such reduction in the energy difference ΔE as illustrated in FIG. 8 and the consequent reduction in the series resistance are considered.

In addition, as a reason for the higher fill factor FF and photoelectric conversion efficiency Eff of Experimental Example 2 as compared to those of Experimental Example 1, the greater reduction in the energy difference ΔE of Experimental Example 2 than in that of Experimental Example 1 is considered.

From the standpoint of reducing the leak current from the CZTS light-absorbing layer 13 to the buffer layer 14 and thereby increasing the open-circuit voltage, it is preferred that there be an energy difference ΔE at the junction between the CZTS light-absorbing layer 13 to the buffer layer 14.

Thus, from the standpoint of the balance between the reduction in the series resistance and the reduction in the leak current, it is preferred to set a chalcogen ratio in the region 13a.

In order to ensure an energy difference ΔE, it is preferred that the energy level at the lower end of the conduction band of the buffer layer be higher than the energy level at the lower end of the conduction band of the CZTS light-absorbing layer 13 prior to the increase in the sulfur concentration, specifically prior to the increase in the ratio of the sulfur concentration with respect to a sum of the sulfur concentration and the selenium concentration. From this standpoint, for example, when Cu₂ZnSnSe₄ or Cu₂ZnSn(Se,S)₄ is used for the CZTS light-absorbing layer 13, it is preferred to use a CdS-based buffer layer or a ZnS-based buffer layer as the buffer layer 14.

In the present invention, the solar cell and the method of manufacturing a solar cell according to the above-described embodiment can be modified as appropriate as long as the modification does not deviate from the gist of the present invention. Moreover, the required constituents of one embodiment can be applied as appropriate to other embodiments as well.

For instance, in the above-described embodiment, the chalcogen ratio in the depth direction of the CZTS light-absorbing layer 13 increases continuously toward the interface on the buffer layer 14 side; however, the increase of the chalcogen ratio may be discontinuous in the form of stepwise increase or the like.

The above-described constitution of the CZTS light-absorbing layer 13 is one example, and the CZTS light-absorbing layer 13 may further contain other component(s) as long as it contains at least selenium and sulfur.

Further, the above-described constitution of the buffer layer 14 is also one example, and the buffer layer 14 may also contain other component(s) as long as the energy level at the lower end of the conduction band of the buffer layer 14 is higher than that of the CZTS light-absorbing layer 13 prior to an increase in the chalcogen ratio.

The present inventors further investigated sulfurization of the vicinity of the surface of the Cu₂ZnSn(S,Se)₄ by a vapor phase method as an alternative to the above-described use of an aqueous solution containing an organic sulfur compound.

The present inventors produced a solar cell including, as the CZTS light-absorbing layer 13, Cu₂ZnSn(S,Se)₄ subjected to an increase in S atoms or substitution of Se atoms with S atoms by a vapor phase method, and evaluated the photoelectric conversion efficiency of the thus obtained solar cell. As a result, the photoelectric conversion efficiency of this solar cell was found to be lower than that of a solar cell including pre-sulfurization Cu₂ZnSnSe₄ as the CZTS light-absorbing layer 13.

This is believed to be caused by defects due to the increased S atom content in the crystals of Cu₂ZnSn(S,Se)₄ in which the S atom content was increased or Se atoms were substituted with S atoms by the vapor phase method. Furthermore, it is speculated that, in the sulfurization of Cu₂ZnSnSe₄ by the vapor phase method, substitution of Se atoms with S atoms extended to the entirety of the layer in the depth direction.

Accordingly, it is believed that, in the Cu₂ZnSn(S,Se)₄ sulfurized by the vapor phase method, defects attributed to the increase in S atoms occurred throughout the entire layer, reducing the photoelectric conversion efficiency.

Therefore, it was found that the use of an aqueous solution containing an organic sulfur compound is more suitable than the use of a vapor phase method as a method of sulfurizing the vicinity of the surface of the selenium-containing CZTS light-absorbing layer 13.

The present inventors explained the band structures illustrated in FIG. 8 as a reason why a solar cell produced by the method of manufacturing a solar cell according to the present invention exhibits favorable fill factor FF and photoelectric conversion efficiency Eff. However, the present inventors do not exclude the possibility that the reason for the improvement in the properties of the solar cell of the present invention is different from the idea illustrated in FIG. 8 or that another reason is also applicable.

### Description of Symbols

- 10: Solar cell
- 11: Substrate
- 12: First electrode layer
- 13: CZTS light-absorbing layer
- 13a: Region
- 14: Buffer layer
- 15: Second electrode layer

## Claims

1. A method of manufacturing a solar cell, the method comprising the steps of:
forming a first electrode layer on a substrate;
forming a selenium-containing p-type CZTS light-absorbing layer on the first electrode layer;
bringing a surface of the CZTS light-absorbing layer into contact with an aqueous solution containing an organic sulfur compound so as to increase the sulfur concentration on the surface of the CZTS light-absorbing layer;
forming an n-type buffer layer on the CZTS light-absorbing layer; and
forming a second electrode layer on the buffer layer.

2. The method of manufacturing a solar cell according to claim 1, wherein the organic sulfur compound contains thiourea, thioacetamide, or a mixture thereof.

3. The method of manufacturing a solar cell according to claim 1 or 2, wherein the energy level at the lower end of the conduction band of the buffer layer is higher than the energy level at the lower end of the conduction band of the CZTS light-absorbing layer prior to the increase in the sulfur concentration with respect to a sum of the sulfur concentration and the selenium concentration.

4. The method of manufacturing a solar cell according to claim 3, wherein a CdS-based buffer layer or a ZnS-based buffer layer is formed as the buffer layer.

5. A solar cell, comprising:
a substrate;
a first electrode layer arranged on the substrate;
a p-type CZTS light-absorbing layer that is arranged on the first electrode layer and comprises selenium and sulfur;
an n-type buffer layer arranged on the CZTS light-absorbing layer; and
a second electrode layer arranged on the buffer layer,
wherein
in the depth direction of the CZTS light-absorbing layer, the ratio of the sulfur concentration with respect to a sum of the sulfur concentration and the selenium concentration increases toward an interface on the buffer layer side.

6. The solar cell according to claim 5, wherein, in the depth direction of the CZTS light-absorbing layer, the ratio of the sulfur concentration with respect to the sum of the sulfur concentration and the selenium concentration increases from a part at a depth of 50 nm from the interface on the buffer layer side toward the interface on the buffer layer side.

7. The solar cell according to claim 5 or 6, wherein, in the depth direction of the CZTS light-absorbing layer, the ratio of the sulfur concentration with respect to the sum of the sulfur concentration and the selenium concentration increases to at least 1.2 times toward the interface on the buffer layer side.

8. The solar cell according to any one of claims 5 to 7, wherein the buffer layer is a CdS-based buffer layer or a ZnS-based buffer layer.
